# EUROPEAN PATENT APPLICATION

(11) **EP 2 512 046 A2**
(43) Date of publication of application: **17.10.2012**
(21) Application number: 12161949.8
(22) Date of filing: 29.03.2012
(51) Int. Cl.: H04H 60/43, H04H 60/51, H04N 21/438, H04N 21/45, H03J 1/00, H03J 7/18, H04N 21/422

(54) **An apparatus and associated methods**

(30) Priority: 12.04.2011 GB 201106166
(71) Applicant: Nokia Corporation, 02150 Espoo (FI)
(72) Inventor: Kangas, Mika Petteri, 90150 Oulu (FI); Luhtala, Harri Petteri, 90570 Oulu (FI); Scales, James, Hurst, Berkshire RG10 0DS (GB)
(74) Representative: Nokia Corporation

(57) **Abstract**

An apparatus comprising a processor and memory including computer program code, the memory and the computer program code configured to, with the processor, cause the apparatus to scan an electromagnetic spectrum for broadcast signals with respect to a signal strength threshold, the signal strength threshold based on at least one criterion, and detect any broadcast signals having a signal strength greater than or equal to the signal strength threshold, wherein a geographical location criterion comprises a current geographical location of the apparatus, and wherein the apparatus is configured to set the signal strength threshold according to the current geographical location of the apparatus.

## Description

### Technical Field

The present disclosure relates to the field of broadcast signals, associated methods and apparatus, and in particular concerns setting a signal strength threshold based on at least one criterion in order to detect a particular number of broadcast signals within a reasonable period of time. Certain disclosed example aspects/embodiments relate to portable electronic devices, in particular, so-called hand-portable electronic devices which may be hand-held in use (although they may be placed in a cradle in use). Such hand-portable electronic devices include so-called Personal Digital Assistants (PDAs).

The portable electronic devices/apparatus according to one or more disclosed example aspects/embodiments may provide one or more audio/text/video communication functions (e.g. tele-communication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM/DRM/DAB) radio broadcast recording/playing), downloading/sending of data functions, image capture function (e.g. using a (e.g. in-built) digital camera), and gaming functions.

### Background

Radio receivers suitable for audio broadcasts (e.g. in-car stereos) are configured to scan the electromagnetic spectrum for broadcast signals, and detect any signals which are transmitted with signal strengths above a predetermined signal strength threshold. The signal strength threshold is typically set during manufacture of the receiver and cannot be adjusted later. This can cause problems during use of the receiver. For example, if the signal strength threshold is set too high, the receiver may not detect certain signals during the scan. This might include the signal that the user is most interested in detecting. On the other hand, if the signal strength threshold is set too low, then the receiver may detect too many signals. The user would then have to go through each of the many detected signals in order to find the one that he/she is most interested in, which could take some time. Detecting too many signals can also be a problem if there is a very limited amount of memory available for storing radio stations. For example, some devices are capable of storing a maximum of 20 stations. In this scenario, it may not be possible to store the station that the user is most interested in if another 20 stations have already been detected and stored during the scan. In general, detecting too few or too many broadcast signals both adversely affect the user experience.

The listing or discussion of a prior-published document or any background in this specification should not necessarily be taken as an acknowledgement that the document or background is part of the state of the art or is common general knowledge. One or more aspects/embodiments of the present disclosure may or may not address one or more of the background issues.

### Summary

According to a first aspect, there is provided an apparatus comprising:
a processor and memory including computer program code, the memory and the computer program code configured to, with the processor, cause the apparatus to:
   scan the electromagnetic spectrum for broadcast signals with respect to a set signal strength threshold, the set signal strength threshold based on at least one criterion; and
   detect any broadcast signals having a signal strength greater than or equal to the set signal strength threshold.

The signal strength threshold may range from -100dBm to -40dBm. In particular, a typical signal strength threshold may be -93dBm. In practice though, the actual threshold values will depend on the receiver design. For example, superheterodyne receivers use frequency mixing or heterodyning to convert a received signal to a fixed intermediate frequency, which can be more conveniently processed than the original radio carrier frequency. However, the intermediate frequency (IF) stages of the receiver add noise to the incoming signal. As a result, the signal strength threshold needs to be increased to compensate for the added noise. In contrast, receivers which use direct digital down conversion do not introduce the same level of noise, and can therefore operate at a lower signal strength threshold. It should therefore be noted that any specific threshold values quoted in the specification are merely examples, and the present invention is not limited to these particular values.

The at least one criterion may comprise at least one of a geographical location criterion and a particular number criterion. The signal strength threshold may be set automatically by the apparatus, or manually by a user of the apparatus. The apparatus may be configured to set the signal strength threshold according to the geographical location criterion and/or the particular number criterion.

The geographical location criterion may comprise the current geographical location of the apparatus. The apparatus may be configured to set the signal strength threshold according to the current geographical location of the apparatus. The apparatus may be configured to determine the current geographical location of the apparatus, and use the determined current geographical location in setting the signal strength threshold. The apparatus may be configured to set the signal strength threshold according to the current geographical location of the apparatus by selecting a particular signal strength threshold from a list of geo-specific signal strength thresholds available to the apparatus.

The apparatus may be configured to determine the current geographical location of the apparatus by detecting at least one of a country, county, city, or area in which the apparatus is currently located. The apparatus may be configured to determine the current geographical location of the apparatus by detecting the country code using a telecommunications network connection available to the apparatus. The apparatus may be configured to determine the current geographical location of the apparatus using data provided by a GNSS receiver available to the apparatus. The apparatus may be configured to determine the current geographical location of the apparatus using RDS or RBDS data contained within a detected broadcast signal.

The particular number criterion may comprise a particular number of broadcast signals to be detected. The apparatus may be configured to set the signal strength threshold according to the particular number of broadcast signals to be detected. The particular number of broadcast signals to be detected may correspond to the amount of memory and/or the number of memory slots available to the apparatus for storing information associated with detected broadcast signals. The particular number of broadcast signals to be detected may be defined by a manufacturer or user of the apparatus.

The apparatus may be configured to: perform a first scanning iteration using a first set signal strength threshold to detect scanned broadcast signals having a signal strength greater than or equal to the first set signal strength threshold; determine whether the number of detected scanned broadcast signals meets the particular number criterion and/or whether a termination criterion has been met; and provide the detected scanned broadcast signals for user selection if the particular number criterion or the termination criterion have been met, otherwise, perform at least one further scanning iteration using at least one further set signal strength threshold to detect scanned broadcast signals having a signal strength greater than or equal to the at least one further set signal strength threshold until the particular number criterion or the termination criterion have been met, and then provide the detected scanned broadcast signals for user selection.

The provision of user selection may encompass allowing the user to manually select at least one of the detected broadcast signals, and/or allowing the apparatus to automatically play at least one of the detected broadcast signals. In the latter scenario, the user may have some control over the signals which the apparatus plays automatically (e.g. the user sets the apparatus to play the strongest signal, the first detected signal, the first signal in the list, or a preselected signal).

The apparatus may be configured to: perform a first scanning iteration using a first set signal strength threshold to detect scanned broadcast signals having a signal strength greater than or equal to the first set signal strength threshold; determine whether the number of detected scanned broadcast signals meets the particular number criterion and/or whether a termination criterion has been met; and provide the detected scanned broadcast signals for user selection if the particular number criterion or the termination criterion have been met, otherwise, perform a second scanning iteration using a second set signal strength threshold to detect scanned broadcast signals having a signal strength greater than or equal to the second set signal strength threshold, and predict a further signal strength threshold suitable for meeting the particular number criterion by interpolating or extrapolating the number of scanned broadcast signals detected using the first and second set signal strength thresholds.

The first set signal strength threshold may be at least one of a midpoint in a range of possible signal strength thresholds, a threshold chosen by a manufacturer of the apparatus, a user-selectable threshold chosen by a user of the apparatus, and a geo-specific threshold based on the current geographical location of the apparatus.

The particular number of broadcast signals to be detected may comprise a predetermined range. The particular number criterion may be met when the number of detected scanned broadcast signals falls within the predetermined range.

The apparatus may be configured to set the signal strength threshold for the second or further scanning iterations according to whether the number of detected scanned broadcast signals falls above or below the predetermined range. The apparatus may be configured to increase or decrease the signal strength threshold with respect to the signal strength threshold used in the preceding scanning iteration if the number of detected scanned broadcast signals falls above or below the predetermined range, respectively.

The signal strength threshold may be increased or decreased by a predetermined step size. The predetermined step size may be based on the current geographical location of the apparatus and/or the number of detected broadcast signals having a signal strength greater than or equal to the set signal strength threshold.

The termination criterion may comprise a manual termination event. The termination criterion may be met on occurrence of the manual termination event. The manual termination event may comprise manual termination of the scanning procedure by a user of the apparatus. The termination criterion may comprise a predetermined timeout period. The termination criterion may be met on expiration of the predetermined timeout period. The termination criterion may comprise a maximum and/or minimum signal strength threshold. The termination criterion may be met when the set signal strength threshold used in the current scanning iteration is equal to the maximum or minimum signal strength threshold.

At least one of the predetermined timeout period, the maximum signal strength threshold, and the minimum signal strength threshold may be defined by a manufacturer or user of the apparatus.

The apparatus may be configured to store information associated with the detected scanned broadcast signals. The information may comprise the transmission frequency and/or station name associated with each detected broadcast signal. The apparatus may be configured to store the signal strength thresholds with or without the number of broadcast signals detected using each signal strength threshold.

The apparatus may be configured to present the detected broadcast signals to a user of the apparatus as a list. The detected broadcast signals may be listed based on their associated transmission frequency and/or station name.

The broadcast signals may comprise at least one of the following: audio data, video data, RDS data, and RBDS data. When the broadcast signals comprise RDS or RBDS data, the apparatus may be configured to detect and/or store only the transmission frequency information of the RDS/RBDS data (as well as the audio/video data) in order to minimize the scan time. The broadcast signals may be broadcast within a frequency range of 30kHz-300GHz. The broadcast signals may be radio and/or television signals. The radio signals may comprise at least one of Frequency Modulation (FM), Amplitude Modulation (AM), Digital Radio Mondiale (DRM), or digital audio broadcasting (DAB) radio signals.

The apparatus may comprise a receiver. The broadcast signals may be detected using the receiver.

The apparatus may be one or more of the following: an electronic device, a portable electronic device, a portable telecommunications device, a radio, a television, an in-car stereo, and a module for any of the aforementioned devices.

According to a further aspect, there is provided a method comprising:
scanning the electromagnetic spectrum for broadcast signals with respect to a set signal strength threshold, the set signal strength threshold based on at least one criterion; and
detecting any broadcast signals having a signal strength greater than or equal to the set signal strength threshold.

The steps of any method disclosed herein do not have to be performed in the exact order disclosed, unless explicitly stated or understood by the skilled person.

According to a further aspect, there is provided a computer program comprising computer code configured to perform any method described herein. The computer program may be stored on a non-transitory computer-readable memory medium.

The apparatus may comprise a processor configured to process the code of the computer program. The processor may be a microprocessor, including an Application Specific Integrated Circuit (ASIC).

The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 shows a list of detected broadcast signals with a signal strength greater than or equal to a set signal strength threshold;
Figure 2 shows how the number of transmitters, and therefore the number of broadcast signals, can vary with geographical location;
Figure 3 shows a flow chart illustrating an implementation of the method described herein;
Figure 4 shows a flow chart illustrating another implementation of the method described herein;
Figure 5 shows a flow chart illustrating yet another implementation of the method described herein;
Figure 6 shows a device comprising the apparatus described herein;
Figure 7 shows the key steps of the method described herein; and
Figure 8 shows a computer readable medium providing a computer program for carrying out the method described herein.

### Description of Specific Aspects/Embodiments

When information is sent via radio transmission, a data signal is overlaid on a carrier wave and transmitted at the carrier frequency. By overlaying the data signal on the carrier wave, a property of the carrier (such as the frequency, amplitude or phase) becomes modulated. A radio receiver, which is tuned to the carrier frequency, then detects the modulated carrier wave and transforms the modulation into a recognisable form (e.g. sound).

Most modern radio (and television) tuners incorporate an "auto-tune" function. This function allows the radio receiver to automatically scan the different frequencies of the electromagnetic spectrum for broadcast signals. During the scanning procedure, the radio receiver detects any broadcast signals having a signal strength greater than or equal to the signal strength threshold of the receiver. Signal strength (also known as received signal level or field strength) refers to the magnitude of electric field at a reference point which is a significant distance from the transmitting antenna. In the case of receivers, the reference point would be the location of the receiver. Typically, signal strength is expressed in decibels referenced to one milliwatt (dBm).

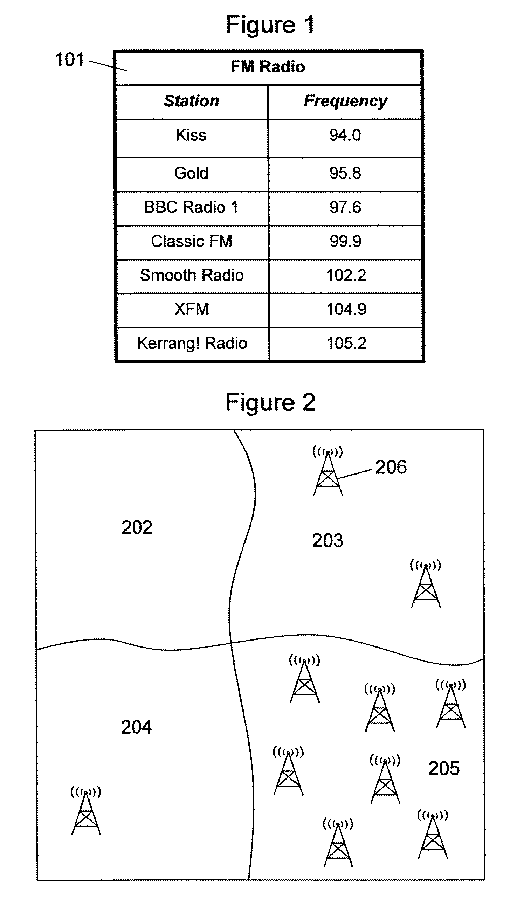

When the radio receiver detects the broadcast signals, it will usually store some information associated with the detected signals, such as the transmission frequency and/or station name. If the radio receiver forms part of a stereo having an electronic display, the stereo may present the detected signals to the user via the electronic display. This is illustrated in Figure 1, where the detected signals have been presented as a list 101. In this example, the signals are ordered according to their associated transmission frequency, but they could be ordered according to station name (e.g. in alphabetical order). Once the scan has been completed, the user can scroll through the list 101 of detected broadcast signals and select a desired signal.

As mentioned in the background section, the signal strength threshold is typically set during manufacture of the receiver and cannot be adjusted later. This can result in the receiver detecting too few or too many broadcast signals. This issue is most problematic when the radio receiver is portable, as the number of broadcast signals usually varies from one geographical location to another.

Figure 2 shows four different geographical regions 202-205, each comprising a different number of radio transmitters 206 (e.g. different radio stations). The regions 202-205 may be different countries, counties, cities, or areas. Typically, the signal strength threshold of a receiver is set to suit the number of radio stations likely to be detected in the country in which the receiver is made. Therefore, if the receiver was manufactured for use in region 204, the signal strength threshold may be set to a relatively low value (e.g. -100dBm) to ensure that the receiver is capable of detecting as many radio stations as possible (given the small number of stations in this region 204). On the other hand, if the receiver was manufactured for use in region 205, the signal strength threshold may be set to a relatively high value (e.g. -40dBm) in order to restrict the number of radio stations detected (given the large number of stations in this region 205). Likewise, if the receiver was manufactured for use in region 203, the signal strength threshold may be set to some intermediate value (e.g. -70dBm).

Now assume that the radio receiver made for use in region 204 is used in region 205. In this scenario, because the set signal strength threshold is so low, and because the number of radio stations in region 205 is so high, the list of detected broadcast signals is overpopulated. This is undesirable because the user would then have to go through each of the many radio stations in order to find the one that he/she is most interested in, which could take some time.

The opposite situation arises if the radio receiver made for use in region 205 is used in region 204. In this scenario, because the set signal strength threshold is so high, and because the number of radio stations in region 204 is so low, the list of detected broadcast signals is under populated. This is also undesirable because the user may not be able to select the radio station that he/she is most interested in.

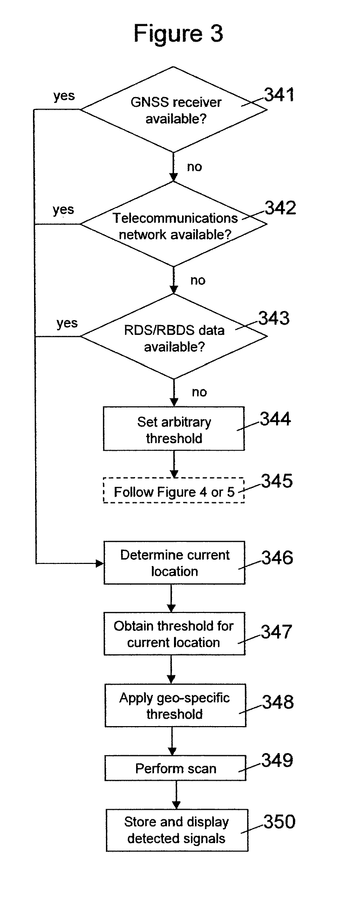

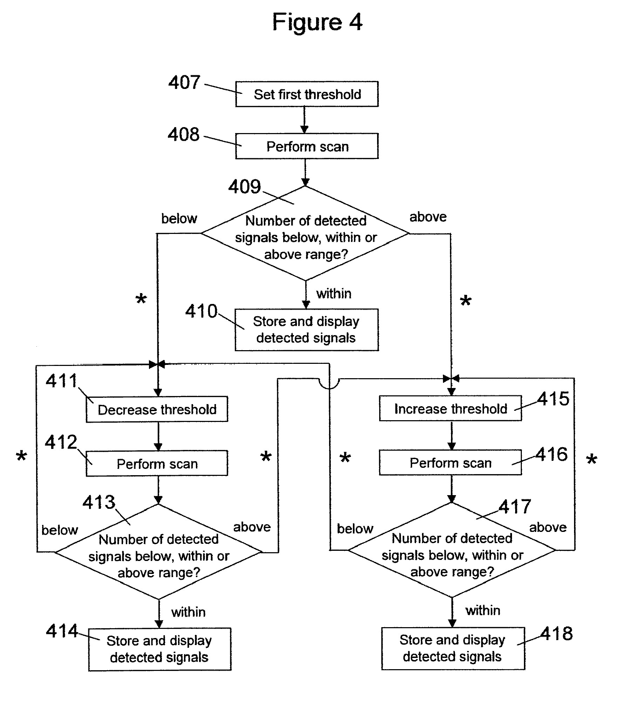

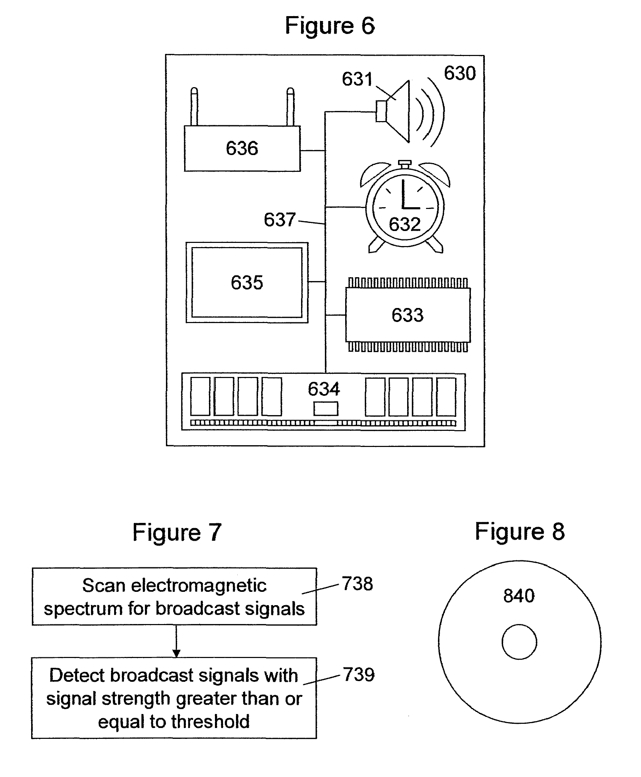

There will now be described an apparatus and method which may or may not address this issue. The main steps 638-639 of the method described herein are illustrated schematically in Figure 6, whilst two possible examples of how the present disclosure may be implemented are illustrated as flow charts in Figures 3 and 4.

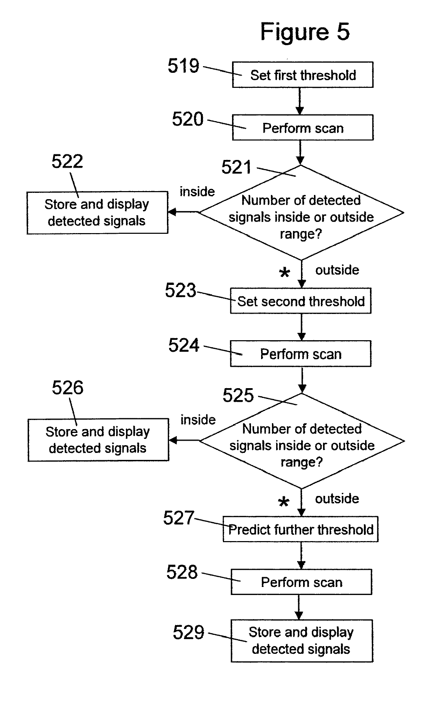

The apparatus (which will be described in detail later with reference to Figure 5) is configured to scan the electromagnetic spectrum for broadcast signals with respect to a set signal strength threshold, and detect any broadcast signals having a signal strength greater than or equal to the set signal strength threshold. To address the above-mentioned issues, however, the set signal strength threshold of the present apparatus is based on at least one criterion.

In one embodiment, the criterion is a geographical location criterion, and the apparatus is configured to set the signal strength threshold according to the geographical location criterion. For example, the apparatus may be configured to determine its current geographical location (e.g. country, county, city, or area), and set the signal strength threshold according to the current geographical location. In this way, it does not matter if the apparatus is manufactured for use in one region but is then used in one or more different regions having different numbers of broadcast signals, because the set signal strength threshold is adjusted to suit the current geographical location. For example, if the apparatus initially has a low signal strength threshold corresponding to the small number of radio stations in region 204, and is moved to region 205 for use, the apparatus will detect the change in location and increase the signal strength threshold to suit the greater number of radio stations in region 205.

There are a number of different ways in which the apparatus could detect the current location. One option might be that the apparatus determines the current geographical location by detecting the country code (possibly including the additional location area code) using a telecommunications network connection available to the apparatus. Another option might be that the apparatus determines the current geographical location using data provided by a global navigation satellite system (GNSS) receiver available to the apparatus. Yet another option might be that the apparatus determines the current geographical location using RDS/RBDS data (e.g. program identification and extended country codes) contained within a detected broadcast signal. The use of a global navigation satellite system may be advantageous in the sense that a GNSS receiver can provide a more accurate location determination than a telecommunications network (e.g. specific coordinates rather than a country or area), but possibly disadvantageous in the sense that the GNSS receiver may increase the cost and complexity of the apparatus. The option adopted by the apparatus may be determined by what information or technology is available to the apparatus at any given time. In some embodiments, the apparatus may be configured to try each option in turn until it determines the current geographical location.

For example, as illustrated in Figure 3, the apparatus may be configured to first determine 341 whether or not a GNSS receiver is available for detecting the current geographical location. If there is no GNSS receiver available (e.g. because the apparatus does not comprise a GNSS receiver), then the apparatus may be configured to determine 342 whether or not there is a telecommunications network available instead. If there is no network available (e.g. because the network coverage at that particular time/location is weak), then the apparatus may be configured to determine 343 whether or not there is any RDS/RBDS data available within a detected broadcast signal.

In the event that a GNSS receiver, a telecommunications network, or RDS/RBDS data is available, then the apparatus may be configured to use the receiver/network/data to determine 346 the current geographical location. Once the current geographical location is known, the apparatus can then obtain 347 and apply 348 the corresponding geo-specific threshold, perform 349 a scan of the electromagnetic spectrum and detect 350 any broadcast signals having a signal strength greater than or equal to the geo-specific threshold.

On the other hand, if there is no GNSS receiver, telecommunications network, or RDS/RBDS data available, then the apparatus may be configured to set 344 an arbitrary threshold value and follow 345 the procedure outlined in Figure 4 or 5.

There are also a number of different ways in which the apparatus could obtain the correct signal strength threshold setting for the current location. One option might be that the apparatus selects a particular signal strength threshold from a list of geo-specific signal strength thresholds stored on the apparatus. Another option might be that the apparatus selects a particular signal strength threshold from a list of geo-specific signal strength thresholds stored on a database server located remote to the apparatus. In the latter scenario, the apparatus may be configured to communicate with the database server over a wired or wireless connection in order to obtain the correct signal strength threshold settings. The use of a database server may be advantageous when the apparatus comprises only a small amount of memory, but the time taken to obtain threshold settings from the database will typically be greater than the time taken to obtain threshold settings from a storage medium located at the apparatus. The use of a database server is also dependent upon the connection.

In another embodiment of the present disclosure, the criterion is a particular number criterion, and the apparatus is configured to set the signal strength threshold according to the particular number criterion. For example, the apparatus may be configured to set the signal strength threshold according to a particular number of broadcast signals to be detected. The particular number of broadcast signals to be detected might be a specific predetermined number (e.g. 5, 10, 15, 20, or 25 signals), or a predetermined range (e.g. up to 1-5, 6-10, 11-15, 16-20, or 21-25 signals), and may correspond with the amount of memory and/or the number of memory slots available to the apparatus for storing information associated with detected broadcast signals. Furthermore, the particular number of broadcast signals to be detected may be defined by a manufacturer or user of the apparatus, and may or may not be adjustable. This embodiment is illustrated in Figure 4.

First of all, the apparatus sets 407 an initial threshold and performs 408 a first scanning iteration for broadcast signals using this initial threshold. The initial threshold may be a midpoint in a range of possible signal strength thresholds, a threshold chosen by a manufacturer of the apparatus, a user-selectable threshold chosen by a user of the apparatus, or a geo-specific threshold based on the current geographical location of the apparatus. Once the scan is complete, the apparatus then determines 409 whether the number of detected broadcast signals meets the particular number criterion (e.g. is the number of detected signals below, within or above the predetermined range?). In the example illustrated, the particular number criterion is met when the number of detected broadcast signals falls within the predetermined range. When this occurs, the apparatus provides 410 the detected signals for user selection (which may involve storage and display of the detected signals).

On the other hand, if the number of detected broadcast signals does not meet the particular number criterion (e.g. because the number of detected signals falls outside the predetermined range), the apparatus performs 412, 416 at least one further scanning iteration using at least one further (different) signal strength threshold until the particular number criterion has been met 413, 417, and then provides 414, 418 the detected signals for user selection. The number of scanning iterations required to meet the particular number criterion will depend on how many broadcast signals are detected at each threshold, and will typically vary.

The apparatus is configured to set the signal strength threshold for the further scanning iterations according to whether the number of detected broadcast signals falls above or below the predetermined number/range to be detected. For example, as shown in the flowchart of Figure 4, when the number of detected signals falls below the predetermined range, the apparatus decreases 411 the threshold to try and increase the number of detected signals. In contrast, when the number of detected signals falls above the predetermined range, the apparatus increases 415 the threshold to try and decrease the number of detected signals.

The signal strength threshold may be increased or decreased by a predetermined step size (e.g. 10dBm, 20dBm, or 50dBm). The predetermined step size is typically chosen to produce the desired number of detected broadcast signals within the shortest period of time. To achieve this, the step size may be related to the current geographical location of the apparatus. For example, if the apparatus is currently located in region 204 of Figure 2, the chosen step size may be relatively large (e.g. 50dBm). This is because there are very few broadcasting stations known/registered in this region, so increasing or decreasing the threshold by a large amount is unlikely to cause a large decrease or increase in the number of detected signals, respectively. The same cannot be said for region 205. In this region, the chosen step size may be relatively small (e.g. 10dBm) to provide greater control of the number of detected broadcast signals. This is because there are so many broadcasting stations known/registered in this region that a large increase or decrease in the threshold is likely to cause a large decrease or increase in the number of detected signals, respectively.

Rather that basing the step size on geographical location, it may be based on the number of signals detected during the preceding scan. This has the same effect as above, but does not require additional hardware for determining the current geographical location (such as a GNSS receiver).

To limit the amount of time spent scanning for signals, the apparatus may also incorporate a termination criterion. This is useful when the current geographical location does not contain very many broadcasting stations (such as regions 202 and 204 of Figure 2), because no matter how long the apparatus spends scanning the electromagnetic spectrum, there is only ever going to be a small number of detected signals. In this respect, there is no point in spending long periods of time trying to satisfy the particular number criterion when the specific predetermined number or the predetermined range is unobtainable for the current geographical location.

In this embodiment, as well as determining whether the number of detected signals meets the particular number criterion has been met, the apparatus also determines whether the termination criterion has been met. The apparatus may determine whether the termination criterion has been met at specific points during the procedure, at regular intervals, or even continually. In the example shown in Figure 4, determination of the termination criterion (indicated by asterisks to avoid cluttering the flowchart) occurs after the apparatus has performed each scanning iteration and determined whether the number of detected signals meets the particular number criterion. If the termination criterion has been met, the apparatus provides the detected signals for user selection. On the other hand, if the termination criterion has not been met, the apparatus continues with the subsequent scanning iterations as described previously.

The termination criterion may be implemented in a number of different ways. For example, the termination criterion might comprise a manual termination event, and may be met on occurrence of the manual termination event. The manual termination event may involve manual termination of the scanning procedure by a user of the apparatus, such as the user pressing a button or electronic display of the apparatus. The apparatus may provide the signals detected during the preceding scanning iteration for user selection as soon as the user initiates the termination. However, if the user initiates the termination mid-scan, the apparatus may provide the signals detected during the current scanning iteration for user selection after the current scanning iteration has been completed.

Additionally or alternatively, the termination criterion may comprise a predetermined timeout period (e.g. 10secs, 20secs, 30secs, 60secs, or 100secs), and may be met on expiration of the predetermined timeout period. The predetermined timeout period may be set by a manufacturer or user of the apparatus, and may be adjustable. The predetermined timeout period may be calculated from when the initial threshold is set, from when the first scan is started, from when the first scan is completed, or from when the radio receiver is switched on or activated. The apparatus may provide the signals detected during the preceding scanning iteration for user selection as soon as the predetermined timeout period expires. However, if the predetermined timeout period expires mid-scan, the apparatus may provide the signals detected during the current scanning iteration for user selection after the current scanning iteration has been completed.

Additionally or alternatively, the termination criterion may comprise a maximum (e.g. - 40dBm) and/or minimum (e.g. -100dBm) signal strength threshold, and may be met when the signal strength threshold used in the current scanning iteration is equal to the maximum or minimum signal strength threshold. The maximum and/or minimum threshold may be set by a manufacturer or user of the apparatus, and may be adjustable. Furthermore, the maximum threshold may correspond with the maximum signal strength achievable using a particular type of transmitter, and the minimum threshold may correspond with the minimum signal strength which is detectable using a particular type of receiver. If the current signal strength threshold is equal to the maximum or minimum signal strength threshold, the apparatus may provide the signals detected during the current scanning iteration for user selection as soon as the current scanning iteration is complete.

Figure 5 illustrates another embodiment of the present disclosure. In this embodiment, the apparatus sets 519 an initial threshold and performs 520 a first scanning iteration for broadcast signals using this initial threshold. As before, the initial threshold may be a midpoint in a range of possible signal strength thresholds, a threshold chosen by a manufacturer of the apparatus, a user-selectable threshold chosen by a user of the apparatus, or a geo-specific threshold based on the current geographical location of the apparatus. Once the first scan is complete, the apparatus then determines 521 whether the number of detected broadcast signals meets the particular number criterion (as described above). In the example illustrated, the particular number criterion is met when the number of detected broadcast signals falls within a predetermined range.

If the number of detected broadcast signals meets the particular number criterion, the apparatus provides 522 the detected signals for user selection (which may involve storage and display of the detected signals, and/or automatic playing of a particular detected signal). On the other hand, if the number of detected broadcast signals does not meet the particular number criterion (e.g. because the number of detected signals falls outside the predetermined range), the apparatus performs 524 a second scanning iteration using a second 523 (different) signal strength threshold. The second threshold may be greater than or less than the first threshold. Furthermore, the second threshold may be preset by a manufacturer of the apparatus, chosen by a user of the apparatus, or based on the current geographical location of the apparatus. Once the second scan is complete, the apparatus again determines 525 whether the number of detected broadcast signals meets the particular number criterion. If the number of detected broadcast signals meets the particular number criterion, the apparatus provides 526 the detected signals for user selection. However, if the number of detected broadcast signals does not meet the particular number criterion, the apparatus predicts 527 a further signal strength threshold suitable for meeting the particular number criterion by interpolating or extrapolating the number of broadcast signals detected using the first and second signal strength thresholds.

In this embodiment, the first and second thresholds (together with the number of broadcast signals detected using each signal strength threshold) form two points on a graph. Therefore, the further signal threshold can be detected by drawing a straight line through the points and reading off the threshold which corresponds to the desired number of detected signals. Whether the further signal strength threshold is determined by interpolation or extrapolation depends on whether the desired number of detected signals falls between the points on the graph or not, respectively. It should be noted, however, that whilst Figure 5 shows the prediction of the further signal strength threshold using two points (i.e. two previous threshold values and corresponding numbers of detected signals), the further signal strength threshold could be predicted more accurately using more than two points (i.e. several previous threshold values and corresponding numbers of detected signals). In this scenario, the graph may be parabolic or hyperbolic rather than a straight line graph, and statistics may be used to obtain a best-fit line through the data points before reading off the threshold which corresponds to the desired number of detected signals.

Once the further signal strength threshold has been predicted, the apparatus performs 528 a final scan using the further signal strength threshold, and provides 529 the detected signals for user selection.

In this embodiment, the apparatus may be configured to store the signal strength thresholds together with the number of broadcast signals detected using each signal strength threshold so that this data can be used to predict the further signal strength threshold.

Although a greater amount of processing power is required to perform the interpolation/extrapolation, this embodiment is advantageous in the sense that it reduces the number of scanning iterations (and therefore time) required to achieve the desired number of detected broadcast signals.

Furthermore, the termination criterion described previously may also be applied to this embodiment (as indicated by the asterisks) to limit the scanning time. As before, the termination criterion may comprise a manual termination event, a predetermined timeout period, and/or maximum and minimum signal strength thresholds.

The apparatus may be configured to adopt the geographical location criterion in the first instance, and adopt the particular number criterion only in the event that it cannot determine the current geographical location.

Greater detail of the apparatus 630 will now be provided with reference to Figure 6. The apparatus 630 comprises a loudspeaker 631, a timer module 632, a processor 633, a storage medium (or memory) 634, an electronic display 635, and a receiver 636, which are electrically connected to one another by a data bus 637. The apparatus 630 may be an electronic device, a portable electronic device, a portable telecommunications device, a radio, a television, an in-car stereo, or a module for any of the aforementioned devices. It will be appreciated that any reference herein to a processor 633 and a storage medium 634 may be a reference to one more processors or storage media/memories.

The receiver 636 is configured to scan the electromagnetic spectrum for broadcast signals with respect to a set signal strength threshold, and detect broadcast signals having a signal strength greater than or equal to the set signal strength threshold. The receiver 636 may also be configured to pass any data contained within the broadcast signals to the loudspeaker 631 and/or electronic display 635 for output/presentation. The receiver 636 may form part of a transceiver, and may be configured to detect radio (FM, AM, DRM, or DAB) and/or television (analogue or digital) signals broadcast within a frequency range of 30kHz-300GHz. The broadcast signals may comprise audio data, video data, RDS data, and/or RBDS data.

The processor 633 is configured for general operation of the apparatus 630 by providing signalling to, and receiving signalling from, the other device components to manage their operation. Furthermore, the processor 633 is configured to perform the procedural steps described herein (and illustrated in Figures 3-5). In particular, the processor 633 is configured to set the signal strength threshold of the receiver 636 based on the geographical location and/or particular number criteria, and is also configured to terminate the scanning/detection procedure based on the termination criterion. The processor 630 may be a microprocessor, including an Application Specific Integrated Circuit (ASIC).

The storage medium 634 is configured to store computer code configured to perform, control or enable operation of the apparatus 630, as described with reference to Figure 8. The storage medium 634 may be configured to store information associated with the detected broadcast signals, such as the transmission frequencies and/or the station names. The storage medium 634 may also be configured to store any audio data, video data, RDS data, and/or RBDS data contained within the broadcast signals. The storage medium 634 may also be configured to store the signal strength thresholds and the predetermined threshold step sizes, with or without the number of broadcast signals detected using each signal strength threshold. In addition, the storage medium 634 may be configured to store the particular number of broadcast signals to be detected (which may be a specific predetermined number or a predetermined range), the predetermined timeout period, and the maximum and minimum threshold limits. Furthermore, the storage medium 634 may be configured to store settings for the other device components. When the storage medium 634 is used to store settings for the other device components, the processor 633 may access the storage medium 634 to retrieve the settings in order to manage operation of the other device components.

In addition, the storage medium 634 may be configured to store details of a graphical user interface which enables a user to control the functionality of the apparatus 630. In particular, the graphical user interface may enable the user to set/adjust the signal strength threshold, terminate the scanning procedure, and select a detected broadcast signal.

The storage medium 634 may be a temporary storage medium such as a volatile random access memory. On the other hand, the storage medium 634 may be a permanent storage medium such as a hard disk drive, a flash memory, or a non-volatile random access memory.

In one embodiment, the timer module 632 is configured to determine whether the predetermined timeout period has expired, and provide signalling to the receiver 636 to terminate scanning accordingly. In another embodiment, these functions may be performed by the processor 633, with the timer module 632 being used merely to keep time. The timer module 632 may comprise software and/or hardware.

The electronic display 635 is configured to present the detected broadcast signals to a user of the apparatus (e.g. as a list). The electronic display 635 may list the detected broadcast signals based on their associated transmission frequency and/or station name. The electronic display 635 may also be configured to present the graphical user interface to the user, and convert visual data obtained from the receiver 636 or storage medium 634 into images which are visible to the user. For example, the electronic display 635 may be configured to present text, pictures, and/or videos obtained from the receiver 636 or storage medium 634. The electronic display 635 may be an organic LED, inorganic LED, electrochromic, electrophoretic, or electrowetting display, and may be touch sensitive (comprising resistive, surface acoustic wave, capacitive, force panel, optical imaging, dispersive signal, acoustic pulse recognition, or bidirectional screen technology).

The loudspeaker 631 is configured to convert audio data obtained from the receiver 636 or storage medium 634 into sound which is audible to the user. For example, the loudspeaker 631 may be configured to output music or traffic information broadcast by a local radio station.

In embodiments where the apparatus is a radio receiver module for a device, the radio receiver module may be mass produced to be inexpensive. In such situations, it may have a very limited amount of memory. It will therefore be appreciated that use of the aforementioned criteria may allow for effective utilisation (e.g. based on varying user requirements) of the limited memory as a user travels from region to region.

Figure 8 illustrates schematically a computer/processor readable medium 840 providing a computer program according to one embodiment. In this example, the computer/processor readable medium 840 is a disc such as a digital versatile disc (DVD) or a compact disc (CD). In other embodiments, the computer/processor readable medium 840 may be any medium that has been programmed in such a way as to carry out an inventive function. The computer/processor readable medium 840 may be a removable memory device such as a memory stick or memory card (SD, mini SD or micro SD).

The computer program may comprise computer code configured to perform, control or enable one or both of the following method steps: scanning the electromagnetic spectrum for broadcast signals with respect to a set signal strength threshold, the set signal strength threshold based on at least one criterion; and detecting any broadcast signals having a signal strength greater than or equal to the set signal strength threshold.

It will be appreciated to the skilled reader that any mentioned apparatus/device/server and/or other features of particular mentioned apparatus/device/server may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some embodiments, a particular mentioned apparatus/device/server may be pre-programmed with the appropriate software to carry out desired operations, and wherein the appropriate software can be enabled for use by a user downloading a "key", for example, to unlock/enable the software and its associated functionality. Advantages associated with such embodiments can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

It will be appreciated that any "computer" described herein can comprise a collection of one or more individual processors/processing elements that may or may not be located on the same circuit board, or the same region/position of a circuit board or even the same device. In some embodiments one or more of any mentioned processors may be distributed over a plurality of devices. The same or different processor/processing elements may perform one or more functions described herein.

It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/embodiments may consist of any such individual feature or combination of features. In view of the foregoing description it will be evident to a person skilled in the art that various modifications may be made within the scope of the disclosure.

While there have been shown and described and pointed out fundamental novel features as applied to different embodiments thereof, it will be understood that various omissions and substitutions and changes in the form and details of the devices and methods described may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or embodiment may be incorporated in any other disclosed or described or suggested form or embodiment as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. An apparatus comprising:
a processor and memory including computer program code, the memory and the computer program code configured to, with the processor, cause the apparatus to:
scan an electromagnetic spectrum for broadcast signals with respect to a signal strength threshold, the signal strength threshold based on at least one criterion; and
detect any broadcast signals having a signal strength greater than or equal to the signal strength threshold,
wherein a geographical location criterion comprises a current geographical location of the apparatus, and wherein the apparatus is configured to set the signal strength threshold according to the current geographical location of the apparatus.

2. The apparatus of claim 1, wherein the at least one criterion comprises at least one of a geographical location criterion and a particular number criterion, and wherein the apparatus is configured to set the signal strength threshold according to the geographical location criterion and/or the particular number criterion from at least one of the following,
a) wherein the apparatus is configured to determine the current geographical location of the apparatus, and use the determined current geographical location in setting the signal strength threshold,
or
b) wherein the apparatus is configured to set the signal strength threshold according to the current geographical location of the apparatus by selecting a particular signal strength threshold from a list of geo-specific signal strength thresholds available to the apparatus, or
c) wherein the apparatus is configured to determine the current geographical location of the apparatus by detecting at least one of a country, county, city, or area in which the apparatus is currently located,
or
d) wherein the apparatus is configured to determine the current geographical location of the apparatus by detecting a country code using a telecommunications network connection available to the apparatus,
or
e) wherein the apparatus is configured to determine the current geographical location of the apparatus using data provided by a GNSS receiver available to the apparatus,
or
f) wherein the apparatus is configured to determine the current geographical location of the apparatus using RDS or RBDS data contained within a detected broadcast signal.

3. The apparatus of any of claim 2, wherein the particular number criterion comprises a particular number of broadcast signals to be detected, and wherein the apparatus is configured to set the signal strength threshold according to the particular number of broadcast signals to be detected.

4. The apparatus of claim 3, wherein the particular number of broadcast signals to be detected corresponds to the amount of memory and/or the number of memory slots available to the apparatus for storing information associated with detected broadcast signals.

5. The apparatus of claims 3 or 4, wherein the particular number of broadcast signals to be detected is defined by a manufacturer or user of the apparatus.

6. The apparatus of any of claims 2 to 5, wherein the apparatus is configured to:
perform a first scanning iteration using a first signal strength threshold to detect scanned broadcast signals having a signal strength greater than or equal to the first signal strength threshold;
determine whether the number of detected scanned broadcast signals meets the particular number criterion and/or whether a termination criterion has been met; and
provide the detected scanned broadcast signals for user selection if the particular number criterion or the termination criterion have been met, otherwise, perform at least one further scanning iteration using at least one further signal strength threshold to detect scanned broadcast signals having a signal strength greater than or equal to the at least one further signal strength threshold until the particular number criterion or the termination criterion have been met, and then provide the detected scanned broadcast signals for user selection.

7. The apparatus of any of claims 2 to 6, wherein the apparatus is configured to:
perform a first scanning iteration using a first signal strength threshold to detect scanned broadcast signals having a signal strength greater than or equal to the first signal strength threshold;
determine whether the number of detected scanned broadcast signals meets the particular number criterion and/or whether a termination criterion has been met; and
provide the detected scanned broadcast signals for user selection if the particular number criterion or the termination criterion have been met, otherwise, perform a second scanning iteration using a second signal strength threshold to detect scanned broadcast signals having a signal strength greater than or equal to the second signal strength threshold, and predict a further signal strength threshold suitable for meeting the particular number criterion by interpolating or extrapolating the number of scanned broadcast signals detected using the first and second signal strength thresholds.

8. The apparatus of any of claims 2 to 7, wherein the particular number of broadcast signals to be detected comprises a predetermined range, and wherein the particular number criterion has been met when the number of detected scanned broadcast signals falls within the predetermined range.

9. The apparatus of claim 8, wherein the apparatus is configured to set the signal strength threshold for the second or further scanning iterations according to whether the number of detected scanned broadcast signals falls above or below the predetermined range.

10. The apparatus of claim 9, wherein the apparatus is configured to increase or decrease the signal strength threshold with respect to the signal strength threshold used in the preceding scanning iteration if the number of detected scanned broadcast signals falls above or below the predetermined range, respectively.

11. The apparatus of any of claims 7 to 9, wherein the termination criterion at least one of the following,
a) comprises a predetermined timeout period, and wherein the termination criterion is met on expiration of the predetermined timeout period,
or
b) comprises a maximum and/or minimum signal strength threshold, and wherein the termination criterion is met when the signal strength threshold used in the current scanning iteration is equal to the maximum or minimum signal strength threshold,
or
c) wherein at least one of the predetermined timeout period, the maximum signal strength threshold, and the minimum signal strength threshold are defined by a manufacturer or user of the apparatus,
or
d) wherein the first signal strength threshold is at least one of a midpoint in a range of possible signal strength thresholds, a threshold chosen by a manufacturer of the apparatus, a user-selectable threshold chosen by a user of the apparatus, and a geo-specific threshold based on the current geographical location of the apparatus.

12. The apparatus of any of claims 1 to 11, wherein the signal strength threshold is increased or decreased by a predetermined step size,
or
uses the predetermined step size is based on the current geographical location of the apparatus and/or the number of detected broadcast signals having a signal strength greater than or equal to the signal strength threshold.

13. The apparatus of any preceding claims, wherein the apparatus is configured to store information associated with the detected scanned broadcast signals for at least one of the following forms,
a) wherein the information comprises the transmission frequency and/or station name associated with each detected broadcast signal,
or
b) wherein the apparatus is configured to present the detected broadcast signals to a user of the apparatus as a list,
or
c) wherein the detected broadcast signals are listed based on their associated transmission frequency and/or station name,
or
d) wherein the apparatus is configured to store the signal strength thresholds with or without the number of broadcast signals detected using each signal strength threshold,
or
e) wherein the broadcast signals comprise at least one of the following: audio data, video data, RDS data, and RBDS data.

14. The apparatus of claim 13, where the signal strength thresholds are for at least one of the following,
a) wherein the broadcast signals are broadcast within a frequency range of 30kHz-300GHz,
or
b) wherein the broadcast signals are radio and/or television signals,
or
c) wherein the radio signals comprise at least one of FM, AM, DRM, or DAB radio signals, or
d) wherein the apparatus comprises a receiver, and wherein the broadcast signals are detected using the receiver.

15. The apparatus of any preceding claims, wherein the signal strength threshold is set automatically by the apparatus, or manually by a user of the apparatus.

16. The apparatus of any preceding claims, wherein the apparatus is one or more of the following: an electronic device, a portable electronic device, a portable telecommunications device, a radio, a television, an in-car stereo, and a module for any of the aforementioned devices, wherein the means for performing comprise at least one processor and at least one memory including executable instructions configured to perform a least one of the functions,
a) to determine the current geographical location of the apparatus, and use the determined current geographical location in setting the signal strength threshold,
or
b) to set the signal strength threshold according to the current geographical location of the apparatus by selecting a particular signal strength threshold from a list of geo-specific signal strength thresholds available to the apparatus,
or
c) determine the current geographical location of the apparatus by detecting at least one of a country, county, city, or area in which the apparatus is currently located,
or
d) determine the current geographical location of the apparatus by detecting a country code using a telecommunications network connection available to the apparatus.

17. A method comprising:
scanning the electromagnetic spectrum for broadcast signals with respect to a signal strength threshold, the signal strength threshold based on at least one criterion of current geographic location; and performing at least one of the following,
a) detecting any broadcast signals having a signal strength greater than or equal to the signal strength threshold wherein the information comprises the transmission frequency and/or station name associated with each detected broadcast signal,
or
b) wherein the apparatus is configured to present the detected broadcast signals to a user of the apparatus as a list,
or
c) wherein the detected broadcast signals are listed based on their associated transmission frequency and/or station name,
d) wherein the apparatus is configured to store the signal strength thresholds with or without the number of broadcast signals detected using each signal strength threshold,
or
e) wherein the broadcast signals comprise at least one of the following: audio data, video data, RDS data, and RBDS data,
and
wherein the signal strength threshold is increased or decreased by a predetermined step size,
or
uses the predetermined step size is based on the current geographical location of the apparatus and/or the number of detected broadcast signals having a signal strength greater than or equal to the signal strength threshold.

18. A computer program comprising computer code configured to perform the method of claim 17.
